# EUROPEAN PATENT SPECIFICATION

(11) **EP 2 682 447 B1**
(45) Date of publication and mention of the grant of the patent: **13.07.2016**
(21) Application number: 12194536.4
(22) Date of filing: 28.11.2012
(51) Int. Cl.: C09K 11/80, G02F 1/1335, H01L 33/50

(54) **METHOD OF MANUFACTURING NANOPHOSPHORS, LIGHT EMITTING DIODE AND METHOD OF MANUFACTURING LIGHT EMITTING DIODE**
VERFAHREN ZUR HERSTELLUNG VON NANOLEUCHTSTOFFEN, LICHTEMITTIERENDE DIODE UND VERFAHREN ZUR HERSTELLUNG EINER LICHTEMITTIERENDEN DIODE
PROCÉDÉ DE FABRICATION DE NANOLUMINOPHORES, DIODE ÉLECTROLUMINESCENTE ET PROCÉDÉ DE FABRICATION DE DIODE ÉLECTROLUMINESCENTE

(30) Priority: 03.07.2012 KR 20120072161
(43) Date of publication of application: 08.01.2014
(73) Proprietor: Samsung Display Co., Ltd., Gyeonggi-do (KR)
(72) Inventor: Shin, Myeong Ju, Seoul, 5-505 (KR); Baek, Seung Hwan, Seoul 304 (KR); Lee, Yeong Bae, Suwon-si, Gyeonggi-do, 532-1701 (KR); Park, Chan Jae, Osan-si, 111-704 Gyeonggi-do (KR)
(74) Representative: Dr. Weitzel & Partner

(56) References cited:
- WO-A2-2011/040709
- US-A1- 2007 222 369
- US-A1- 2008 185 956
- US-A1- 2009 085 467
- US-A1- 2011 114 985
- US-A1- 2011 305 005

## Description

### BACKGROUND

### (a) Field

The invention relates to a method of manufacturing a nanophosphor and a method of manufacturing a light emitting diode.

### (b) Description of the Related Art

A light emitting diode ("LED") is a photoelectric device automatically emitting light when electrically connected to a power source. The LED has various merits in that size reduction and weight lightening are feasible, a quantity of emitted heat is small, a lifespan is long, and a high speed response is feasible as compared to a known electric bulb, such that the LED is used in various electric and electronic goods.

A phosphor material for converting a wavelength used in the LED may be used as a material converting light having a predetermined wavelength of various light sources into light having a desired wavelength. Particularly, among various light sources, the LED may be usefully applied as a liquid crystal display ("LCD") backlight and lamps for vehicles and home due to low power driving and excellent light efficiency, such that the phosphor material is currently in the limelight as an essential technology for manufacturing a white light emitting apparatus.

Luminance needs to be increased in order for the LED to exhibit an excellent characteristic. A nanophosphor having a size contributing to light emission needs to be formed by minimizing crystal defects, minimizing scattering between the phosphor particles and increasing a specific surface area in order to improve luminance of a LED package.

In the related art, the nanophosphor is formed by a liquid-state reaction method or a gas-state reaction method. With the liquid-state reaction method or the gas-state reaction method, crystallization is implemented at low temperatures and the phosphor can be synthesized to have a small sphere form. However, there is a problem in that reproducibility of the size of the particle to be formed and a characteristic of the phosphor are deteriorated.

WO 2011/040709 A2 discloses a method for preparing a (halo)silicate-based phosphor which is prepared, using europium as an active agent, from a (halo)silicate-based host material containing alkaline earth metals. The features already known from this document have been summarized in the preamble of claim 1.

US 2011/305005 A1 discloses a method of manufacturing a YAG:CE phosphor comprising the steps of mixing raw materials and BaF2 flux, sintering, ball-milling and drying to obtain a phosphor with a particle size of 5 to 50 micrometers.

### SUMMARY

The invention provides a method of manufacturing a nanophosphor by using a solid-state reaction method, a method of manufacturing a light emitting diode including the nanophosphor formed by the solid-state reaction method, in detail with the features of claims 1 and 5 respectively. The subclaims define preferred embodiments of the invention.

An exemplary embodiment of the invention provides a method of manufacturing a nanophosphor, the method including: contacting a nanophosphor raw material and a flux, sintering the mixture to form a nanoprecursor, ball-milling the nanoprecursor, and drying the ball-milled nanoprecursor to form the nanophosphor, where an average particle size of the nanophosphor is equal to or more than about 50 nanometers (nm) and equal to or less than about 7 micrometers (um).

The nanophosphor raw material mixed with the flux is in the form of a powder.

The nanophosphor may include a compound represented by any one selected from Y₃Al₅O₁₂:Ce³⁺, Ca₂SiO₄: (Ce³⁺,Li⁺), Sr₂SiO₄: (Eu²⁺,Dy³⁺), SrGa₂S₄:Eu²⁺ or (Sr,Ba)₂Ga₂SiO₇:Eu²⁺.

In the mixing of the nanophosphor raw material and the flux, the nanophosphor raw material includes Y₂O₃ having a particle size of equal to or more than about 40 nm and equal to or less than about 400 nm, Al₂O₃ having a particle size of equal to or more than about 30 nm and equal to or less than about 1 um, and CeO₂ having a particle size of equal to or more than about 50 nm and equal to or less than about 500 nm.

The nanophosphor is a compound represented by Y₃AlₛO₁₂:Ce³⁺.

The sintering the nanophosphor raw material and the flux to form the nanoprecursor is performed at a temperature equal to or more than aboout 1400 degrees Celsius (°C) and equal to or less than about 1600 °C.

The sintering the nanophosphor raw material and the flux to form the nanoprecursor may include performing a first sintering at a temperature equal to or more than about 1500 °C and equal to or less than about 1600 °C for equal to or more than about 1 hours and equal to or less than about 1.5 hours, and performing a second sintering at a temperature equal to or more than about 1400 °C and equal to or less than about 1500 °C for equal to or more than about 3 hours and equal to or less than about 5 hours.

The flux may include a compound including halogen.

The flux may include at least one of NH₄Cl, BaCl₂, AlF₃ or BaF₂.

Another exemplary embodiment of the invention provides a method of manufacturing a light emitting diode, the method including: providing a light emitting portion on a substrate, and providing a sealing layer covering the light emitting portion. The sealing layer includes a nanophosphor dispersed therein. The nanophospor includes a nanophosphor raw material, and an average particle size of the nanophosphor is equal to or more than about 50 nanometers and equal to or less than about 7 micrometers. Mixing the nanophosphor raw material with a flux provides a mixture of the nanophosphor raw material and the flux. Sintering the mixture of the nanophosphor raw material and the flux forms a nanoprecursor. Ball-milling the nanoprecursor forms a ball-milled nanoprecursor, and drying the ball-milled nanoprecursor forms the nanophosphor having the average particle size equal to or more than about 50 nanometers and equal to or less than about 7 micrometers.

The nanophosphor raw material mixed with the flux is in a powder state.

The nanophosphor may include a compound represented by any one selected from Y₃Al₅O₁₂:Ce³⁺, Ca₂SiO₄: (Ce³⁺,Li⁺), Sr₂SiO₄: (Eu²⁺,Dy³⁺), SrGa₂S₄:Eu²⁺ or (Sr,Ba)₂Ga₂SiO₇:Eu²⁺.

In the mixing of the nanophosphor raw material and the flux, the nanophosphor raw material includes Y₂O₃ having a particle size of equal to or more than about 40 nm and equal to or less than about 400 nm, Al₂O₃ having a particle size of equal to or more than about 30 nm and equal to or less than about 1 um, and CeO₂ having a particle size of equal to or more than about 50 nm and equal to or less than about 500 nm.

The nanophosphor is a compound represented by Y₃Al₅O₁₂:Ce³⁺.

The sintering the nanophosphor raw material and the flux to form the nanoprecursor may be performed at a temperature equal to or more than about 1400 °C and equal to or less than about 1600 °C.

The sintering the nanophosphor raw material and the flux to form the nanoprecursor may include performing a first sintering at a temperature equal to or more than about 1500 °C and equal to or less than about 1600 °C for equal to or more than about 1 hour to equal to or less than about 1.5 hours, and performing as second sintering at a temperature equal to or more than about 1400 °C and equal to or less than about 1500 °C for equal to or more than about 3 hours and equal to or less than about 5 hours.

The flux may include a compound including halogen.

The flux may include at least one of NH₄Cl, BaCl₂, AlF₃ or BaF₂.

The method may further include providing a mold frame on an outer side of an upper surface of the substrate.

The sealing layer may urther include a bulky phosphor.

Yet another exemplary embodiment of the present disclosure provides a light emitting diode including: a substrate, a light emitting portion positioned on the substrate, and a sealing layer covering the light emitting portion and including phosphors dispersed therein, where in the phosphor includes a mixture of a nanophosphor and a bulky phosphor, the nanophosphor fills a void between particles of the bulky phosphor, a particle size of the nanophosphor is equal to or more than about 50 nm and equal to or less than about 7 um, and a particle size of the bulky phosphor is equal to or more than about 8 um and equal to or less than about 30 um.

The nanophosphor may be represented by any one selected from Y₃Al₅O₁₂:Ce³⁺, Ca₂SiO₄: (Ce³⁺,Li⁺), Sr₂SiO₄: (Eu²⁺,Dy³⁺), SrGa₂S₄:Eu²⁺ or (Sr,Ba)₂Ga₂SiO₇:Eu²⁺.

A content of the nanophosphor may be equal to or more than about 20 weight percent (wt%) and equal to or less than about 80 wt% of the sealing layer.

Still another exemplary embodiment of the present disclosure provides a liquid crystal display including: a liquid crystal panel, and a backlight unit including a light emitting diode. The light emitting diode includes a substrate, a light emitting portion positioned on the substrate, and a sealing layer covering the light emitting portion and including phosphors dispersed therein. The phosphors include a mixture of a nanophosphor and a bulky phosphor. The nanophosphor fills a void between particles of the bulky phosphor. A particle size of the nanophosphor is equal to or more than about 50 nm and equal to or less than about 7 um, and a particle size of the bulky phosphor is equal to or more than about 8um and equal to or less than about 30 um.

According to one or more exemplary embodiment of the invention, a nanophosphor may be formed by controlling a synthesis temperature and time by a solid-state reaction method to minimize scattering between particles and increase specific surface area, such that the amount of phosphor having a size contributing to light emission is increased to improve light emitting luminance.

### BRIEF DESCRIPTION OF THE DRAWINGS

The above and other features of this disclosure will become more apparent by describing in further detail exemplary embodiments thereof with reference to the accompanying drawings, in which:
FIG. 1 is a flowchart schematically showing an exemplary embodiment of a method of manufacturing a nanophosphor according to the invention.
FIG. 2 is a graph showing an exemplary embodiment of a temperature condition according to time in the sintering process of FIG. 1.
FIG. 3 shows pictures of an exemplary embodiment of a nanophosphor manufactured according to the invention and a general phosphor are compared to each other.
FIG. 4 includes views showing another exemplary embodiment of a phosphor according to the invention.
FIG. 5 is a cross-sectional view showing an exemplary embodiment of a light emitting diode ("LED").

### DETAILED DESCRIPTION

The invention will be described more fully hereinafter with reference to the accompanying drawings, in which exemplary embodiments of the invention are shown. As those skilled in the art would realize, the described embodiments may be modified in various different ways, all without departing from the scope of the claims. The exemplary embodiments that are disclosed herein are provided so that the disclosed contents may become thorough and complete and the invention may be sufficiently understood to a person of an ordinary skill in the art.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. Like reference numerals designate like components throughout the specification. As used herein, the term "and/or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "lower," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" relative to other elements or features would then be oriented "upper relative to the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the invention will be described in detail with reference to the accompanying drawings.

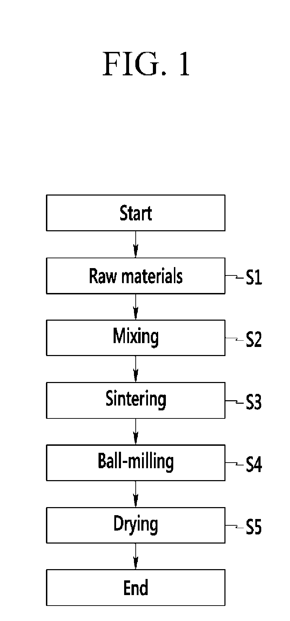

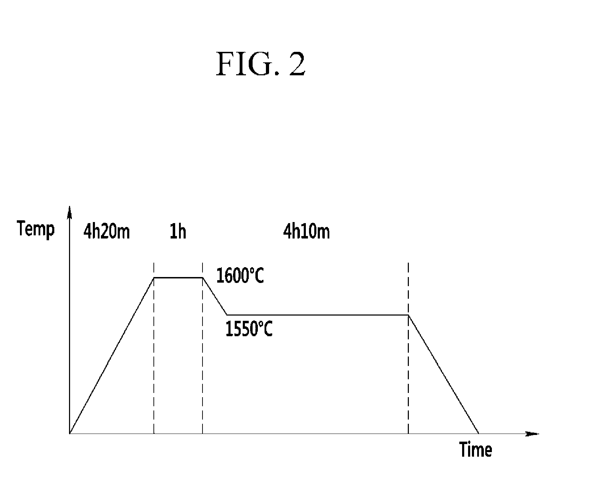

FIG. 1 is a flowchart schematically showing an exemplary embodiment of a method of manufacturing a nanophosphor according to the invention. FIG. 2 is a graph showing an exemplary embodiment of a temperature condition according to time in the sintering step of FIG. 1.

In the exemplary embodiment of a method of manufacturing the nanophosphor according to the invention, materials that are raw materials for forming the nanophosphor are prepared (S1). The nanophosphor raw materials may be present in a powder state, but are not limited thereto or thereby. In one exemplary embodiment, for example, the nanophosphor raw material may collectively include Y₂O₃ having a particle size of equal to or more than about 40 nanometers (nm) and equal to or less than about 400 nm, Al₂O₃ having a particle size of equal to or more than about 30 nm and equal to or less than about 1 micrometer (um), and CeO₂ having a particle size of equal to or more than about 50 nm and equal to or less than about 500 nm.

The prepared nanophosphor raw materials are combined with a flux and filled in a vessel such as a crucible (S2). Since the nanophosphor raw materials are present in the form of a powder, reactivity is low, and the flux may serve to increase the reactivity of the nanophosphor raw materials. In the exemplary embodiment, the flux may be a compound including halogen, and may be a halide, but is not limited thereto or thereby. In exemplary embodiment, the flux may include at least one of NH₄Cl, BaCl₂, AlF₃ and BaF₂.

In a modified exemplary embodiment, a compound formed by a combination of CaCO₃ + H₂SiO₃ + Li₂CO₃ + CeO₂, a combination of SrCO₃ + SiO₂ + Eu₂O₃ + Dy₂O₃, a combination of SrS + Ca₂S₃ + EuS or a combination of SrCO₃ + BaCO₃ + SiO₂ + Ga₂O₃ + Eu₂O₃ may be used as the nanophosphor raw material instead of the aforementioned compound formed by a combination of Y₂O₃+Al₂O₃+CeO₂.

Next, the mixture of the nanophosphor raw material and the flux filled in the vessel is sintered at a relatively high temperatures (S3).

Referring to FIG. 2, slow heating is performed for an initial 4 hours and 20 min (4h20m) to increase the temperature to 1600 degrees Celsius (°C). Next, heating is performed at 1600°C for about one hour (1 h), the temperature is slightly decreased to 1550°C, and a heating state at the 1550°C is maintained for about 4 hours (4h10m).

During sintering, an inert or reducing gas, e.g., a gas mixed with equal to or more than about 5% and equal to or less than about 10% of at least one of hydrogen (H₂) and nitrogen (N₂), by volume, may be used as an inert gas, but should not be limited thereto or thereby.

In one exemplary embodiment, about 1400 °C may be set as a lower limit for ensuring a characteristic of the nanophosphor ,and about 1600 °C may be set as an upper limit for ensuring a controlling property of a nanoparticle size by allowing reactivity not to be excessively increased. Where the temperature is less than 1400°C, the characteristic of the nanophosphor may be deteriorated, and where the temperature is more than 1600°C, reactivity may be increased, accordingly, it may be difficult to control the size of the nanophosphor and the particle size may be undesirably increased. In one exemplary embodiment of the invention, the high temperature sintering temperature is equal to or more than about 1400 °C and equal to or less than about 1600°C.

When the sintering process is finished, the nanophosphor raw materials are reacted with each other to form a nanoprecursor.

Next, the formed nanoprecursor is ball-milled (S4).

The ball-milling of the nanoprecursor serves to react the nanophosphor raw materials such that a connection portion between the nanophosphor particles is broken. The ball-milling may be performed by wet milling, but is not limited thereto or thereby. In one exemplary embodiment, the ball-milling may include mixing ethanol with the nanoprecursor.

Next, the ball-milled nanoprecursor is dried (S5).

The nanophosphor having a general nano-size of equal to or more than about 50 nm and equal to or less than about 500 nm, to a submicro-size of equal to or more than about 500 nm and equal to or less than about 1 um, may be synthesized. The formed and synthesized nanophosphor may be a compound represented by any one of Y₃₋ₓAl₅O₁₂:Ce³⁺ₓ (where x is about 0.1 to about 0.15), Ca₂SiO₄: (Ce³⁺,Li⁺), Sr₂SiO₄: (Eu²⁺,Dy³⁺), SrGa₂S₄:Eu²⁺ or (Sr,Ba)₂Ga₂SiO₇:Eu²⁺, according to a type of nano phosphorescent raw material.

The above-described exemplary embodiment may be considered as excluding *a liquid-state reaction method or a gas-state reaction method.*

The nanophosphor manufactured through this method has a substantially uniform shape and/or size of particles, high reproducibility, and excellent luminance characteristic as compared to the nanophosphor manufactured by the liquid-state reaction method or the gas-state reaction method.

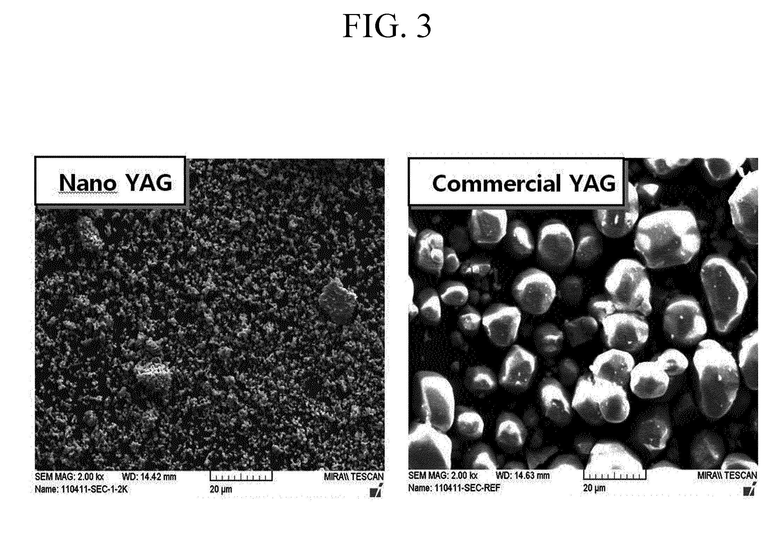

FIG. 3 shows pictures in which an exemplary embodiment of a nanophosphor manufactured according to the invention and a general phosphor are compared to each other.

Referring to FIG. 3, a left view shows a nanophosphor having the nanosize of equal to or more than about 50 nm and equal to or less than about 7 um formed by the exemplary embodiment of the method of manufacturing the nanophosphor according to the invention, and a right picture shows a conventional phosphor having a known microsize.

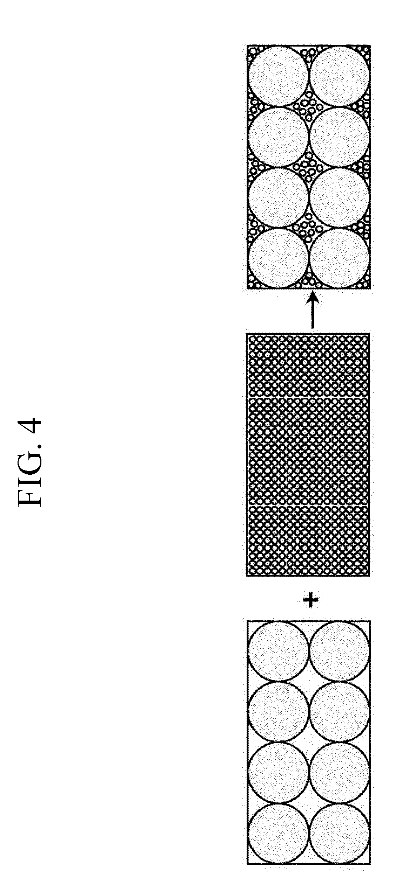

FIG. 4 includes views showing another exemplary embodiment of a phosphor according to the invention.

Referring to FIG. 4, the leftmost view shows a known bulky phosphor having a microsize particle size instead of the nano-size, the middle view shows the aforementioned nanophosphor according to an exemplary embodiment of the invention, and the rightmost view shows the nanophosphor and the bulky phosphor mixed.

In the following Table 1, relative luminances of a Comparative Example, an Example 1 and an Example 2 are compared, while color coordinates are adjusted to be substantially the same as each other.

**Table 1**

| | Powder luminance [%] | Color coordinate [Cx,Cy] | | LED package luminance [%] |
|---|---|---|---|---|
| Comparative Example | 100 | 0.271 | 0.239 | 100 |
| Example 1 | 60 | 0.269 | 0.239 | 97.6 |
| Example 2 | - | 0.270 | 0.237 | 106.8 |

In Table 1, the Comparative Example is the bulky phosphor having a particle size of about 8 um, Example 1 is the nanophosphor having a particle size of about 500 nm, and Example 2 is the bulky phosphor of the Comparative Example and the nanophosphor of Example 1 mixed at a ratio of 1:1.

With respect to of Example 1, luminance of a light emitting diode ("LED") package including the nanophosphor having a particle size of about 500 nm is about 97% as compared to luminance of powder of the nanoparticle is 60%, accordingly, the luminance is increased by 30% or more. If a LED package is formed by mixing the bulky phosphor and the nanophosphor in an exemplary embodiment according to the invention, like in Example 2, luminance is improved by 6.8% compared to an LED package of the Comparative Example including only the bulky phosphor. In Example 2, the particles having the nano-size may fill a void between the bulky phosphor particles and increase a specific surface area per unit volume to improve luminance.

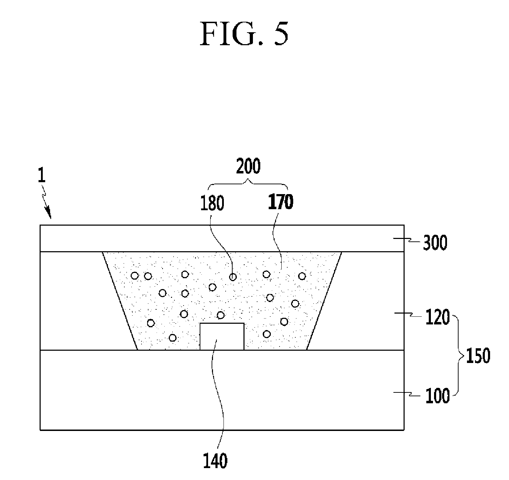

FIG. 5 is a cross-sectional view showing an exemplary embodiment of a LED according to the invention.

Referring to FIG. 5, an exemplary embodiment of a LED according to the invention includes a substrate 100, a mold frame 120 on an upper surface of the substrate 100 and along a periphery of the substrate 100, and a light emitting portion 140 positioned on an exposed portion of the upper surface of the substrate 100 surrounded by the mold frame 120. The substrate 100 and the mold frame 120 may be integral such that a single, unitary, indivisible member is formed, but should not be limited thereto or thereby.

A package 150 collectively including the substrate 100 and the mold frame 120 serves to protect the light emitting portion 140 from external moisture.

The LED 1 may further include a sealing layer 200 which fills a space defined by the substrate 100, the mold frame 120 and the light emitting portion 140. The sealing layer 200 collectively includes a mixture of the nanophosphor 170 and the bulky phosphor 180 which are dispersed in the space.

Although not shown in the drawing, the light emitting portion 140 may include a light emitting chip, a lead pattern, and/or a wiring connecting the light emitting chip and the lead pattern. The lead pattern is an electrode pattern, and serves to apply external power to the light emitting chip.

The light emitting chip may be a horizontal type light emitting chip including an N-type electrode and a P-type electrode on a same flat or planar surface thereof, and mounted on the lead pattern, but should not be limited thereto or thereby. Alternatively, the light emitting chip may be a vertical type light emitting chip including the P-type electrode on an upper portion and the N-type electrode on a lower portion of a plate.

The sealing layer 200 seals the light emitting portion 140 to protect the light emitting portion 140, and acts as a protection body. The phosphors 170 and 180 dispersed in the sealing layer 200 may include a green phosphor, a red phosphor and/or a yellow phosphor, but are not limited thereto or thereby. Where the phosphors 170 and 180 include a green phosphor, a red phosphor and/or a yellow phosphor, the light emitting portion 140 may be a blue light emitting chip, such that blue light emitted from the blue light emitting chip, and light emitted using the phosphors 170 and 180, may be mixed to output white light.

A content of the nanophosphor in the mixture of the nanophosphor 170 and the bulky phosphor 180 may be equal to or more than about 20 weight percent (wt%) and equal to or less than about 80 wt%. If the content of the nanophosphor is less than 20 wt%, luminance of the LED 1 is deteriorated, and if the content of the nanophosphor is more than 80 wt%, light emitting efficiency of the LED 1 may be deteriorated due to scattering of the phosphor and re-absorption of light, in a LED package including the LED 1.

The nanophosphor 170 included in the exemplary embodiment of the LED 1 may be a compound represented by any one of Y₃Al₅O₁₂:Ce³⁺, Ca₂SiO₄: (Ce³⁺,Li⁺), Sr₂SiO₄: (Eu²⁺,Dy³⁺), SrGa₂S₄:Eu²⁺ or (Sr,Ba)₂Ga₂SiO₇:Eu²⁺. The particle size of the nanophosphor 170 may be the nano-size of equal to or more than about 50 nm and equal to or less than about 7 um, and the particle size of the bulky phosphor 180 may be equal to or more than about 8 um and equal to or less than about 30 um.

The sealing layer 200 may further include a transparent silicon resin or epoxy resin, but is not limited thereto or thereby. In an alternative exemplary embodiment, the sealing layer 200 may further include an opaque resin through which light is capable of being transmitted, according to the purpose of the LED 1.

In the exemplary embodiment of the LED 1 according to the invention, a coating layer 300 may be further on the sealing layer 200. The coating layer 300 covers the sealing layer 200 exposed by the mold frame 120, and the mold frame 120. Although not shown in the drawing, the coating layer 300 may extend to cover a lateral surface of the package 150, but is not limited thereto or thereby. In an alternative exemplary embodiment, the coating layer 300 may be omitted.

Referring to FIG. 5 again, an exemplary embodiment of a method of manufacturing the LED will be described in brief.

Referring to FIG. 5, the mold frame 120 is provided, e.g., formed, on an upper portion of the substrate 100 and along an outside or periphery of the substrate 100. The light emitting portion 140 is provided on the exposed upper portion of the substrate 100, which is surrounded by the mold frame 120. In one exemplary embodiment, the mold frame 120 may be integrally formed with the substrate 100 such as by injection molding, to form a single, unitary, indivisible member, but should not be limited thereto or thereby.

The sealing layer 200 is provided so as to fill a space defined by the mold frame 120 and the light emitting portion 140 in the package 150 which includes the substrate 100 and the mold frame 120. A dispersed mixture of the nanophosphor 170 which may be formed by the aforementioned method of manufacturing the nanophosphor, and the bulky phosphor 180, is provided in the space to form the sealing layer 200. In an alternative exemplary embodiment, the bulky phosphor 180 may not be mixed with the nanophospor 170, and only the nanophosphor 170 may be dispersed in the space to form the sealing layer 200.

The coating layer 300 may be further provided on the sealing layer 200, but may be omitted in alternative exemplary embodiments.

The LED including the aforementioned nanophosphor may be used in a liquid crystal display or the like. Since the liquid crystal display is a light receiving device that does not emit light of itself but controls transmittance of light provided from the outside to display an image, a separate apparatus for radiating light on the liquid crystal panel, that is, a backlight apparatus, is required.

The backlight apparatus serves to guide and diffuse light generated in a light source such as the LED to transfer light to the liquid crystal panel. The LED may include one or more exemplary embodiment of the nanophosphor according to the invention, and the backlight apparatus including the LED may be manufactured and used in the liquid crystal display.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A method of manufacturing a nanophosphor, the method comprising:
contacting a nanophosphor raw material and a flux to form a mixture,
sintering the mixture to form a nanoprecursor,
ball-milling the nanoprecursor, and
drying the ball-milled nanoprecursor to form the nanophosphor,
wherein an average particle size of the nanophosphor is equal to or more than 50 nanometers and equal to or less than 7 micrometers;
wherein:
the nanophosphor raw material is in the form of a powder;
**characterized in that** the nanophosphor is a compound represented by Y₃Al₅O₁₂:Ce³⁺, and
the nanophosphor raw material comprises
Y₂O₃ having a particle size equal to or more than 40 nanometers and equal to or less than 400 nanometers,
Al₂O₃ having a particle size of equal to or more than 30 nanometers and equal to or less than 1 micrometer, and
CeO₂ having a particle size of equal to or more than 50 nanometers and equal to or less than 500 nanometers.

2. The method of manufacturing a nanophosphor of claim 1, wherein:
the nanophosphor is a compound represented by any one of Y₃Al₅O₁₂:Ce³⁺, Ca₂SiO₄: (Ce³⁺,Li⁺), Sr₂SiO₄: (Eu²⁺,Dy³⁺), SrGa₂S₄:Eu²⁺ or (Sr,Ba)₂Ga₂SiO₇:Eu²⁺.

3. The method of manufacturing a nanophosphor of claim 1, wherein:
the sintering of the mixture to form the nanoprecursor comprises sintering at a temperature of equal to or more than 1400 degrees Celsius and equal to or less than 1600 degrees Celsius.

4. The method of manufacturing a nanophosphor of claim 1, wherein:
the flux comprises a compound comprising halogen.

5. A method of manufacturing a light emitting diode, the method comprising:
providing a light emitting portion on a substrate, and
providing a sealing layer covering the light emitting portion, the sealing layer comprising a nanophosphor dispersed therein,
wherein the nanophosphor is manufactured by the method of one of the claims 1, 3 or 4.

6. The method of manufacturing a light emitting diode of claim 5, further comprising:
providing a mold frame on an outer side of an upper surface of the substrate.

7. The method of manufacturing a light emitting diode of claim 5, wherein:
the sealing layer further comprises a bulky phosphor having a particle size in the range of micrometers.

## Patentansprüche

1. Verfahren zur Herstellung eines Nanophosphors, das die Schritte umfasst:
Kontaktieren eines Nanophosphor-Rohmaterials und eines Flussmittels, um ein Gemisch zu bilden,
Sintern des Gemisches, um einen Nano-Precursor zu bilden,
Kugelmahlen des Nano-Precursors, und
Trocknen des kugelgemahlenen Nano-Precursors, um das Nanophosphor zu bilden,
wobei eine mittlere Teilchengröße des Nanophosphors größer oder gleich 50 Nanometer und kleiner oder gleich 7 Mikrometer ist;
wobei das Nanophosphor-Rohmaterial pulverförmig ist;
**dadurch gekennzeichnet, dass**
das Nanophosphor eine Verbindung ist, die durch Y₃Al₅O₁₂:Ce³⁺ dargestellt ist, und
das Nanophosphor-Rohmaterial umfasst:
Y₂O₃ mit einer Teilchengröße größer oder gleich 40 Nanometer und kleiner oder gleich 400 Nanometer,
Al₂O₃ mit einer Teilchengröße größer oder gleich 30 Nanometer und kleiner oder gleich 1 Mikrometer, und
CeO₂ mit einer Teilchengröße größer oder gleich 50 Nanometer und kleiner oder gleich 500 Nanometer.

2. Verfahren zur Herstellung eines Nanophosphors nach Anspruch 1, wobei das Nanophosphor eine Verbindung ist, die durch Y₃Al₅O₁₂:Ce³⁺, Ca₂SiO₄:(Ce³⁺, Li⁺), Sr₂SiO₄:(Eu²⁺, Dy³⁺), SrGa₂S₄:Eu²⁺ oder (Sr, Ba)₂Ga₂SiO₇:Eu²⁺ dargestellt ist.

3. Verfahren zur Herstellung eines Nanophosphors nach Anspruch 1, wobei das Sintern des Gemisches zur Bildung des Nano-Precursors das Sintern bei einer Temperatur größer oder gleich 1400 Grad Celsius und kleiner oder gleich 1600 Grad Celsius umfasst.

4. Verfahren zur Herstellung eines Nanophosphors nach Anspruch 1, wobei das Flussmittel eine Halogen umfassende Verbindung umfasst.

5. Verfahren zur Herstellung einer Leuchtdiode, das die Schritte umfasst:
Bereitstellen eines Leuchtabschnitts auf einem Substrat und
Bereitstellen einer Versiegelungsschicht, die den Leuchtabschnitt bedeckt, wobei die Versiegelungsschicht ein darin dispergiertes Nanophosphor umfasst,
wobei das Nanophosphor durch das Verfahren nach einem der Ansprüche 1, 3 oder 4 hergestellt wird.

6. Verfahren zur Herstellung einer Leuchtdiode nach Anspruch 5, ferner umfassend das Bereitstellen eines Formgestells auf einer Außenseite einer Oberfläche des Substrats.

7. Verfahren zur Herstellung einer Leuchtdiode nach Anspruch 5, wobei die Versiegelungsschicht ferner ein voluminöses Phosphor mit einer Teilchengröße im Mikrometerbereich umfasst.

## Revendications

1. Une méthode de fabrication d'un nanophosphore, la méthode comprenant :
La mise en contact de matière première d'un nanophosphore et d'un flux pour former un mélange,
Le frittage du mélange pour former un nanoprécurseur,
Le broyage à boulets du nanoprécurseur, et
Le séchage du nanoprécurseur broyé par boulets pour former le nanophosphore,
Où une taille de particule moyenne du nanophosphore est égale ou supérieure à 50 nanomètres et égale ou inférieure à 7 micromètres ;
Où:
La matière première du nanophosphore est sous forme de poudre ;
**Caractérisée en ce que**
Le nanophosphore est un composé représenté par Y₃Al₅O₁₂:Ce³⁺, et
La matière première du nanophosphore comprend
Y₂O₃ ayant une taille de particule égale ou supérieure à 40 nanomètres et égale ou inférieure à 400 nanomètres,
Al₂O₃ ayant une taille de particule égale ou supérieure à 30 nanomètres et égale ou inférieure à 1 micromètre, et
CeO₂ ayant une taille de particule égale ou supérieure à 50 nanomètres et égale ou inférieure à 500 nanomètres.

2. La méthode de fabrication d'un nanophosphore de la revendication 1, où :
Le nanophosphore est un composé représenté par un de Y₃Al₅O₁₂:Ce³⁺, Ca₂SiO₄: (Ce³⁺, Li*), Sr₂SiO₄: (Eu²⁺, Dy³⁺), SrGa₂S₄:Eu²⁺ ou (Sr,Ba)₂Ga₂SiO₇:Eu²⁺.

3. La méthode de fabrication d'un nanophosphore de la revendication 1, où :
Le frittage du mélange pour former le nanoprécurseur comprend le frittage à une température égale ou supérieure à 1400 degrés Celsius et égale ou inférieure à 1600 degrés Celsius.

4. La méthode de fabrication d'un nanophosphore de la revendication 1, où :
Le flux comprend un composé comprenant de l'halogène.

5. Une méthode de fabrication d'une diode électroluminescente, la méthode comprenant :
L'apport d'une portion électroluminescente sur un substrat, et
L'apport d'une couche d'étanchéité couvrant la portion électroluminescente, la couche d'étanchéité comprenant un nanophosphore y étant dispersé,
Où le nanophosphore est fabriqué par la méthode de l'une des revendications 1, 3 ou 4.

6. La méthode de fabrication d'une diode électroluminescente de la revendication 5, comprenant de plus :
L'apport d'un cadre de moule sur un côté extérieur d'une surface supérieure du substrat.

7. La méthode de fabrication d'une diode électroluminescente de la revendication 5, où : la couche d'étanchéité comprend de plus un phosphore volumineux ayant une taille de particule dans la gamme des micromètres.
